# EUROPEAN PATENT APPLICATION

(11) **EP 3 018 234 A1**
(43) Date of publication of application: **11.05.2016**
(21) Application number: 14819869.0
(22) Date of filing: 02.07.2014
(51) Int. Cl.: C23C 14/34

(54) **SPUTTERING TARGET AND METHOD FOR MANUFACTURING SAME**

(30) Priority: 05.07.2013 JP 2013141665
(71) Applicant: AGC Ceramics Co., Ltd., Tokyo, 108-0014 (JP)
(72) Inventor: KANDA, Kouichi, Takasago-shi Hyogo 676-8655 (JP); HAYASI, Kyousuke, Takasago-shi Hyogo 676-8655 (JP); KINOSHITA, Shuichi, Takasago-shi Hyogo 676-8655 (JP); ISHIKAWA, Takuya, Takasago-shi Hyogo 676-8655 (JP); FUKUSHIMA, Satoshi, Takasago-shi Hyogo 676-8655 (JP)
(74) Representative: Müller-Boré & Partner Patentanwälte PartG mbB
(86) International application number: PCT/JP2014/067711
(87) International publication number: WO 2015/002253

(57) **Abstract**

To provide a sputtering target which has a target material made of a dense substance and wherein the amount of bonding filler metal used is reduced thereby to make stable film forming operation possible and to reduce the production cost.

A sputtering target 1 having a target material 4 provided, via a bonding filler metal 3, on the surface of a cylindrical substrate 2, wherein the target material 4 is a dense substance having a porosity of no more than 1.5 %, and the thickness of the bonding filler metal 3 is no more than 0.2 mm. This sputtering target 1 can be produced by a simple operation by a cold isostatic pressing method.

## Description

### TECHNICAL FIELD

The present invention relates to a sputtering target and a process for its production, particularly to a sputtering target wherein the amount of bonding filler metal to be used can be reduced and a target material is densely formed, and a process for producing the sputtering target by a cold isostatic pressing method.

### BACKGROUND ART

Sputtering is widely used in various applications, since it is thereby possible to produce a uniform thin film efficiently.

Heretofore, a plate-form sputtering target (planar type) has been used for sputtering, but the utilization ratio of its material has been as low as at most 20%, and there has been such a drawback that continuous sputtering or sputtering of a long object is not possible.

Whereas a cylindrical sputtering target has been developed and used. A cylindrical sputtering target has now been widely used, since the utilization ratio of its material is as high as from 80 to 90%, and it is thereby possible to apply sputtering uniformly to a wide region of e.g. a glass surface.

In order to produce such a cylindrical sputtering target, a thermal spraying method is, for example, known wherein a target material as a mixed powder is melted by means of e.g. plasma generated in an inert gas atmosphere or in the atmospheric air atmosphere, then uniformly thermally sprayed on the outer peripheral surface of a cylindrical substrate and solidified on the surface to form a uniform layer (see e.g.

### Patent Document 1).

Further, a method is known wherein a cylindrical substrate and a cylindrical target material are preliminarily formed, and while their axes are aligned, a bonding agent is injected between the substrate and the target material for bonding (see e.g. Patent Documents 2 and 3).

### PRIOR ART DOCUMENTS

### PATENT DOCUMENTS

Patent Document 1: JP-A-5-86462
Patent Document 2: JP-A-2010-150610
Patent Document 3: JP-A-2011-84795

### DISCLOSURE OF INVENTION

### TECHNICAL PROBLEM

However, by the thermal spraying method, the density of the target material formed around the substrate was relatively low, and it was difficult to form a dense target material. Further, a compressive residual stress works in the target material formed on the substrate, and if thickened, the adhesion force tends to be low, and therefore, in order to maintain the uniformity, it was required to carefully maintain the production conditions, and in order to produce a sputtering target having stabilized properties, it was required to pay close attention.

Whereas, in the method of injecting a bonding agent, in order to sufficiently inject the bonding agent in the space between the substrate and the target material, the space has to be formed to have a sufficient clearance to let the bonding agent be sufficiently injected to inside. Therefore, it was not possible to make the bonding agent thinner than the predetermined thickness, and it was difficult to reduce the amount of the bonding agent to be used. The bonding agent is relatively expensive in many cases, which is also reflected to the cost of the product itself, and therefore, a sputtering target and a process for its production, wherein the amount of the bonding agent used is more reduced, is desired.

Under these circumstances, in order to solve the above problem, it is an object of the present invention to provide a sputtering target which has a target material made of a dense substance and wherein the amount of a bonding agent to be used is reduced, thereby to make stable film forming operation possible and to reduce the production cost, and a process for its production.

### SOLUTION TO PROBLEM

As a result of an extensive study, the present inventors have found it possible to produce, by a prescribed process, a novel sputtering target which has a highly dense, uniform target material and wherein the thickness of a bonding filler metal is made thin to reduce the amount of its use.

The present invention provides the following constructions.
(1) A sputtering target having a target material provided, via a bonding filler metal, on the surface of a cylindrical substrate, wherein the target material is a dense substance having a porosity of no more than 1.5%, and the thickness of the bonding filler metal is no more than 0.2 mm.
(2) The sputtering target according to the above (1), wherein the target material is continuously formed with its length being at least 1.0 m in the axial direction of the substrate.
(3) The sputtering target according to the above (1) or (2), wherein the temperature at which whole or part of the target material becomes a liquid phase, is at most 450°C.
(4) The sputtering target according to the above (3), wherein the target material contains at least one member selected from the group consisting of Zn, Sn and Al.
(5) The sputtering target according to the above (4), wherein the target material is an alloy of Zn-Sn type or Zn-Al type.
(6) The sputtering target according to any one of the above (1) to (5), wherein the melting point of the bonding filler metal is at most 300°C.
(7) The sputtering target according to the above (6), wherein the bonding filler metal is In, an In alloy, Sn or a Sn alloy.
(8) The sputtering target according to any one of the above (1) to (7), wherein the target material is bonded as dispersed in the bonding filler metal at the bonding surface with the bonding filler metal.
(9) A process for producing a sputtering target, which comprises a coating step of applying a bonding filler metal on the surface of a cylindrical substrate, and a pressing step of placing a raw material powder to form a target material, on the surface of the bonding filler metal applied on the surface of the substrate, and subjecting the raw material powder to pressing treatment under a condition of at most 70°C by a cold isostatic pressing method (CIP method) to form a target material.
(10) The process for producing a sputtering target according to the above (9), wherein the cold isostatic pressing method is a wet rubber pressing method.
(11) The process for producing a sputtering target according to the above (9) or (10), wherein the porosity of the target material is no more than 1.5%.
(12) The process for producing a sputtering target according to any one of the above (9) to (11), wherein the thickness of the bonding filler metal is no more than 0.2 mm.
(13) The process for producing a sputtering target according to any one of the above (9) to (12), wherein the target material is continuously formed with its length being at least 1 m in the axial direction of the substrate.

### ADVANTAGEOUS EFFECTS OF INVENTION

According to the sputtering target of the present invention, it is made of a dense target material whereby abnormal electrical discharge (arc discharge) is less likely to occur, and the bonding filler metal is bonded without forming a thermal strain, whereby stabilized film formation can be maintained while uniformly maintaining overall cooling of the target material during sputtering. Further, the amount of bonding filler metal to be used, can be reduced, whereby the production cost can effectively be reduced.

According to the process for producing a sputtering target of the present invention, the above-mentioned sputtering target having a dense target material and having the amount of bonding filler metal reduced, can easily be produced by a simple operation.

### BRIEF DESCRIPTION OF DRAWINGS

Fig. 1 is a schematic cross-sectional view of the sputtering target of the present invention.
Fig. 2A is a view illustrating a process (coating step) for producing the sputtering target of the present invention.
Fig. 2B is a view illustrating a process (pressing step) for producing the sputtering target of the present invention.
Fig. 2C is a view illustrating a process (pressing step) for producing the sputtering target of the present invention.
Fig. 2D is a view illustrating a process (pressing step) for producing the sputtering target of the present invention.
Fig. 2E is a view illustrating a process (grinding process step) for producing the sputtering target of the present invention.

### DESCRIPTION OF EMBODIMENTS

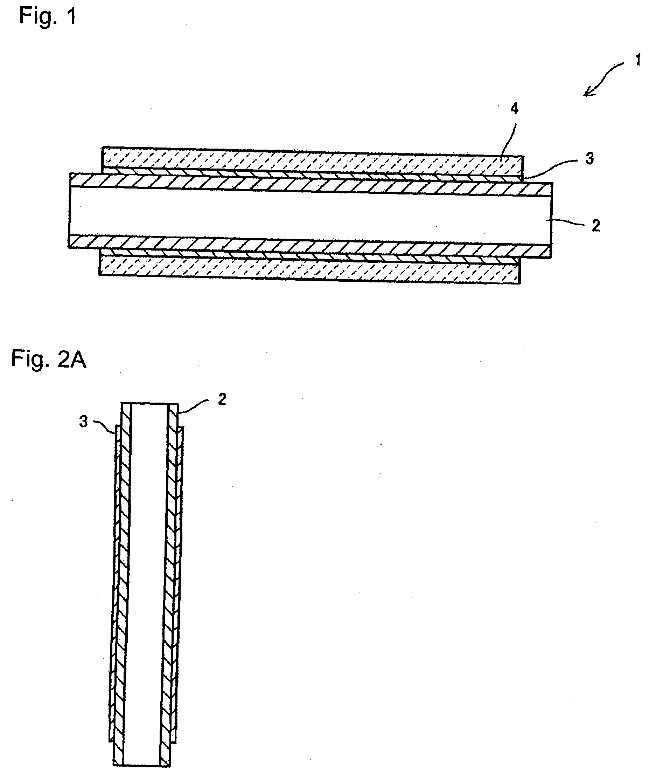

The sputtering target of the present invention has the above-described construction, and, for example, as shown in Fig. 1, a sputtering target 1 comprising a cylindrical substrate 2, a bonding filler metal 3 formed on the surface of the substrate 2, and a target material 4 provided, via the bonding filler metal 3, on the substrate 2, may be exemplified. Now, the sputtering target of the present invention will be described in detail.

The cylindrical substrate 2 to be used in the present invention is a cylindrical substrate expected to have a target material 4 formed on its surface and is preferably one having predetermined thermal conductivity, electrical conductivity, strength, etc. This substrate 2 may, for example, be Fe, Ti, Al or an alloy containing at least one of these metals, such as SUS, a titanium alloy, an aluminum alloy, etc. The outside diameter of the cylindrical substrate is preferably from 3 to 20 cm, the thickness is preferably from 3 to 7 mm, and the length may be optionally determined, but is preferably at least 1.0 m, more preferably at least 1.5 m.

In the present invention, in the production of the sputtering target, a cold isostatic pressing method is used, and therefore, this substrate 2 is preferably one having a high strength so as not to be deformed against the high pressure of the method. Such strength may, for example, be, as 0.2% bearing force, preferably at least 200 MPa, more preferably at least 250 MPa. Here, with respect to the strength, "0.2% bearing force" means a stress with which the tensile strength causes a permanent elongation of 0.2%, and, for example, the 0.2% bearing force of SUS304 is about 250 MPa, and that of a titanium alloy is about 500 MPa.

The bonding filler metal 3 to be used in the present invention is one to bond the cylindrical substrate 2 and the target material 4, and a known one commonly used as a solder may be used. Further, in the present invention, the thickness of the bonding filler metal is preferably no more than 0.2 mm, since it is not required to take into accounts the thermal strain at the time of bonding with the target material, and more preferably no more than 0.1 mm, since the sputtering target can be produced at a lower cost as the amount of the bonding filler metal to be used is smaller. If no bonding filler metal is present, spring back is likely to be caused whereby no bonding with the target material is possible, and therefore, in consideration of the bonding reliability with the target material, the thickness of the bonding filler metal is preferably at least 0.005 mm, particularly preferably within a range of from 0.01 to 0.06 mm.

Such a bonding filler metal preferably has a low melting point, and, for example, the melting point of the bonding filler metal is preferably at most 300°C, more preferably at most 250°C with a view to preventing a thermal strain of the substrate, particularly preferably at most 200°C from the viewpoint of the operation for application of bonding filler metal. When the melting point is at most 300°C, it is possible to efficiently bond the substrate 2 and the target material 4 at the same time of press molding the target material 4 by a cold isostatic pressing method. As such a bonding filler metal, for example, In, an In alloy, Sn or a Sn alloy may be mentioned. The melting point of the bonding filler metal is preferably at least 80°C.

The target material 4 to be used in the present invention may be a known target material so long as it is one press-moldable by a cold isostatic pressing method. Such a target material is made of a dense substance having a porosity of no more than 1.5%, preferably no more than 0.8%, whereby during its use, stabilized sputtering operation can be carried out. Further, by the cold isostatic pressing method, the obtainable target material can be densified by a simple operation and a uniform target material 4 can be formed irrespective of the location for formation on the cylindrical substrate 2. If the porosity of the target material becomes large, abnormal electrical discharge (arc discharge) is likely to occur at the time of sputtering, thereby to scatter a splash which will deposit on the sputtering film, and such a trouble can be prevented by the present invention. The porosity of the target material may be 0%, but is usually at least 0.1 %.

As such a target material 4, preferred is a material which wholly or partly becomes a liquid phase at a temperature of at most 450°C, and such a temperature is more preferably at most 400°C, particularly preferably at most 200°C. As the temperature for such change into a liquid phase is lower, the target material 4 can be densified more efficiently by a cold isostatic pressing method. As the material for such a target material, specifically, Zn, Sn, Al, etc., may, for example, be mentioned, and one containing at least one member selected from them is preferred, and an alloy of Zn-Sn type or Zn-Al type is more preferred. The temperature at which whole or part of the target material becomes a liquid phase is preferably at least 100°C. Zn/Sn i.e. the mass ratio of Zn to Sn in the Zn-Sn type alloy, is preferably from 0.9995/0.0005 to 0.0005/0.9995. Zn/Al i.e. the mass ratio of Zn to Al in the Zn-Al type alloy, is preferably from 0.9998/0.0002 to 0.58/0.42.

The thickness of the target material 4 may be an optional thickness, but since the efficiency in its use becomes high, at least 5 mm is preferred, and at least 10 mm is more preferred. However, if it becomes too thick, uniform molding tends to be difficult even by a cold isostatic pressing method, and therefore, at most 30 mm is preferred, and at most 20 mm is more preferred.

This target material 4 is preferably a target material which is continuously formed on the substrate surface in the axial direction of the cylindrical substrate 2, and its length may be optionally adjusted, but is preferably at least 1.0 m, more preferably at least 1.5 m. By forming it continuously, it is possible to prevent contamination between target material portions in the case of non-continuous formation, and it is possible to reduce possible contamination of a film to be formed by sputtering.

Further, when a target material is continuously formed, particles ejected from the target material at the time of sputtering become uniform, whereby the film forming conditions will be stabilized as compared with a case where it is non-continuously formed, and a film to be thereby formed will be a uniform one.

Now, the process for producing a sputtering target of the present invention will be described.

As mentioned above, the process for producing a sputtering target of the present invention comprises a bonding filler metal coating step of applying a bonding filler metal on the surface of a cylindrical substrate, and a pressing step of placing a raw material powder to form a target material, on the surface of the bonding filler metal applied on the surface of the substrate, and subjecting the raw material powder to pressing treatment under a condition of at most 70°C by a cold isostatic pressing method (CIP method) to form a target material. The following description will be made with reference to Fig. 2A to Fig. 2E.

The bonding filler metal coating step is a step of applying a bonding filler metal 3 on the surface of a cylindrical substrate 2 (Fig. 2A).

Here, the bonding filler metal 3 may be applied by a known coating method, for example, dip coating, spray coating or a method of utilizing ultrasonic vibrations. Here, in the present invention, since it is not required to take into consideration the thermal strain, the thickness of the bonding filler metal is preferably no more than 0.2 mm, more preferably no more than 0.1 mm since the sputtering target can be produced at a lower cost as the amount of the bonding filler metal to be used is smaller. In a case where no bonding filler metal is present, even if CIP-molded, spring back takes place whereby no bonding can be made, and therefore, in consideration of the bonding reliability of the target material, the thickness of the bonding filler metal is preferably at least 0.005 mm, particularly preferably within a range of from 0.01 to 0.06 mm.

The pressing step of the present invention is a step of placing a raw material powder to form a target material, on the surface of the bonding filler metal applied on the surface of the substrate, and subjecting the raw material powder to pressing treatment under a condition of at most 70°C by a cold isostatic pressing method (CIP method). The temperature at which the raw material powder is subjected to pressing treatment by a cold isostatic pressing method (CIP method), is preferably at most 60°C, and is preferably at least 5°C.

In order to carry out this pressing step, firstly a raw material powder to form a target material is placed on the outer peripheral surface of the substrate 2 having the bonding filler metal 3 applied thereon. To place such a raw material powder on the surface of the substrate 2, for example, the substrate 2 may be covered with a covering member of e.g. a rubber or resin having a flexibility deformable by an external pressure, and the raw material powder may be filled in a space between the covering member and the substrate 2. The volume average particle size (D50) of the raw material powder is preferably from 1 to 100 µm.

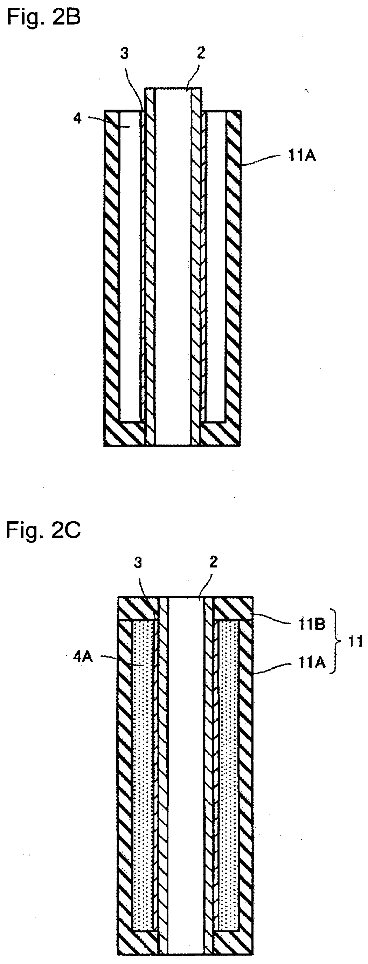

A specific method for placing the raw material powder will be described with reference to Fig. 2B and Fig. 2C. Firstly, on the outer periphery of the substrate 2 having the bonding filler metal 3 formed thereon, a covering main body 11A to be disposed to have a space therefrom, is placed (Fig. 2B). This covering main body 11A is placed in close contact with one end side of the substrate 2 to prevent penetration of a liquid from outside, to the surface of the substrate 2 (the side of the bonding filler metal 3 or the raw material powder to be filled). Here, a liquid may flow into the inside of the cylinder of the substrate 2.

Then, the raw material powder 4A for the target material is filled in a space formed between the substrate 2 and the covering main body 11 A. When the raw material powder 4A is sufficiently filled, a covering cap member 11 B is placed in close contact with the other end side of the substrate 2 (Fig. 2C). This covering cap member 11 B is also set to prevent penetration of a liquid from outside, to the surface of the substrate 2 (the side of the bonding filler metal 3 or the raw material powder 4A to be filled). Thus, the substrate 2 is covered by the covering member 11, and the surface of the substrate 2 (the side of the bonding filler metal 3 and the raw material powder 4A) is hermetically sealed.

Here, it is preferred to permit a liquid to flow into the inside of the cylinder, so that in the CIP method, the pressure exerted from the outside and the pressure exerted from the inside can be utilized to press and mold the target material, such being efficient and at the same time effective to prevent deformation of the substrate 2.

Further, at that time, the covering main body 11 A may be deformed by filling of the raw material powder 4A, and if so deformed, the abundance of the raw material powder 4A is likely to be variable on the surface of the substrate 2. In order to prevent such a trouble, it is preferred to provide a guide member to prevent deformation at the periphery of the covering main body 11A. Such a guide member may be prepared by using a material which has flexibility but has low stretch properties.

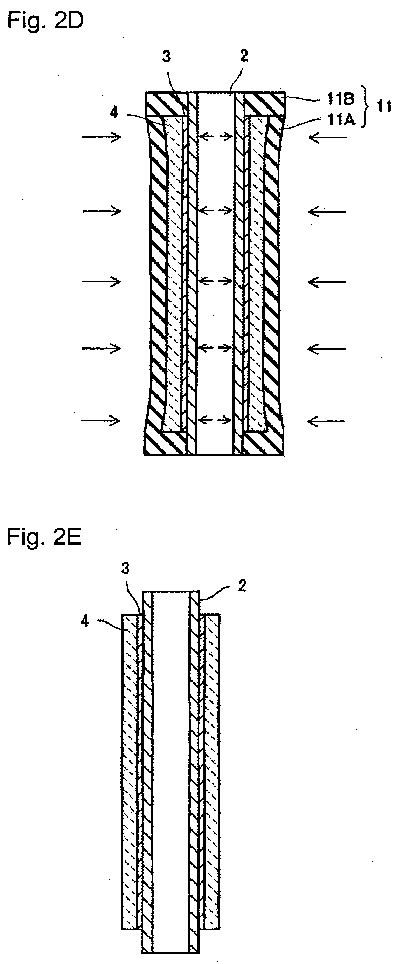

Then, by means of a cold isostatic pressing method, a pressure is exerted to the raw material powder placed on the surface of the substrate 2 to densify the raw material powder 4A to obtain a target material 4 (Fig. 2D). In the case of a metal material having a low melting point, by means of a cold isostatic pressing method, densification can be carried out by exerting a high pressure to the raw material powder 4A e.g. at room temperature by a method different from densification by means of so-called usual heat sintering. For example, the densification can be carried out by immersing the substrate 2 provided with the covering member 11 as described above, in a liquid such as water and mechanically pressing the liquid to uniformly press the raw material powder 4A on the substrate 2 surface.

Thus, heating at a high temperature as in a usual sintering method or thermal spraying method is not involved, whereby a damage to the substrate due to the heat can be avoided. If the damage to the substrate is avoided, reuse may be possible by providing a target material afresh to the substrate for sputtering target once used. With respect to the temperature in this cold isostatic pressing method, the liquid to be used is preferably water at room temperature, and for the purpose of improving the press molding, it may be heated to a temperature at a level where water is not boiled, e.g. to 70°C.

Further, by the cold isostatic pressing method, a uniform pressure can be exerted to the raw material powder, as mentioned above, whereby it is possible to form a uniform target material on the substrate surface. When the target material is uniform, it is possible to carry out the film formation by sputtering under a stabilized condition.

The pressure to be exerted to the raw material powder by this cold isostatic pressing method is not particularly limited so long as it is capable of forming the raw material powder into a target material, and formation of the target material may be carried out under a wide range of pressure conditions. In order to form a denser target material, such pressure is preferably at least 100 MPa, more preferably at least 150 MPa. When the pressure is adjusted to be at least 150 MPa, in the case of a metal material having a low melting point, the porosity of the target material to be formed may be made to be no more than about 1.5%, and a target material made of the above-mentioned dense substance of the present invention may be formed. Further, the higher this pressure, the better, from the viewpoint of densification of the target material. However, a care should be taken not to deform the cylindrical shape of the substrate. For example, the upper limit of this pressure may be the same force as the 0.2% bearing force of the substrate, and the pressure is at most such a pressure.

Further, the pressing time may depend on the pressure to be exerted. Once the pressure reaches the prescribed level, it is not particularly required to maintain the pressure, but the pressing time is preferably about 1 minute to make sure that a uniform pressure is certainly imparted.

Further, by this CIP method, the substrate 2 and the target material 4 will be bonded via the bonding filler metal 3. Here, it is preferred that both the target material 4 and the bonding filler metal 3 have low melting points, so that their atoms tend to be readily mutually diffused by pressing, whereby further improvement of the bonding properties can be expected, and the reliability of the product will be improved.

A cold isostatic pressing method utilizing the pressure of a liquid and using a covering member 11 made of a rubber material such as rubber, as mentioned above, is referred to as a wet rubber pressing method.

The target material 4 thus obtained, may sometimes be such that its surface is not flat and smooth, depending upon the shape of the covering member 11. Particularly, as between the end portions and the center portion of the covering member 11, its deformation degree may be different, and consequently, the thickness of the target material 4 may be different in many cases.

Therefore, with respect to the obtained substrate having a target material formed thereon, it is preferred that the surface of the target material is ground to shape the target material itself into a smooth cylindrical shape and to bring the thickness of the target material formed on the substrate to be uniform (Fig. 2E). By bringing the thickness of the target material to be uniform, it becomes possible to conduct the film forming operation in sputtering under a stabilized condition.

Further, the thickness of the target material to be formed here may be adjusted to be an optional thickness, but from the efficiency at the time of using the target material, the thickness is preferably at least 5 mm, more preferably at least 10 mm. However, if it becomes too thick, uniform molding tends to be difficult even by the cold isostatic pressing method, and therefore, the thickness is preferably at most 30 mm, more preferably at most 20 mm.

### EXAMPLES

Now, the sputtering target of the present invention will be described in detail with reference to Examples, but it should be understood that the present invention is by no means thereby restricted.

### (Example 1)

On the surface of a cylindrical substrate made of SUS and having an outer diameter of 135 mm, an inner diameter of 125 mm and a length of 3,200 mm, In (indium) as a bonding filler metal was uniformly applied in an average thickness of 0.025 mm. This substrate was covered with a covering main body made of chloroprene rubber, and further, the periphery of the covering main body was covered with a guide member made of vinyl chloride. Into a space formed between the substrate and the covering main body, a mixed raw material powder of Zn and Sn (each being 50 wt%) was filled, and with a covering cap member, the periphery of the substrate was hermetically sealed.

The substrate covered by the covering member was immersed in water, and by a wet rubber pressing method, a pressure of 150 MPa was exerted for one minute at water temperature (25°C) to obtain a target material bonded, via the bonding filler metal, to the substrate surface. Further, the surface of this target material was ground to obtain a target material having a uniform thickness. The target material thus obtained had a diameter of 165 mm, a length of 3,000 mm and a thickness of 15 mm (one side), and its porosity was 0.36%. The bonding strength at the bonding surface between the bonding filler metal and the target material, cut out, was 100 kg/cm².

In film forming by this sputtering target, even if the input power was raised to 25 kW per 1 m in length of the target, no abnormal discharge was observed, and it was possible to conduct good film formation.

### (Example 2)

A sputtering target was prepared in the same manner as in Example 1 except that the mixed raw material powder was changed to 98 wt% of Zn and 2 wt% of Al, and the pressure by the wet rubber pressing method was changed to 190 MPa, whereby the results were the same except that the porosity was 0.79%, and the bonding strength was 85 kg/cm².

### (Example 3)

A sputtering target was prepared in the same manner as in Example 2 except that as the bonding filler metal, Sn (tin) was used, whereby the results were the same as in Example 2 except that the bonding strength was 55 kg/cm².

### (Example 4)

A sputtering target was prepared in the same manner as in Example 1 except that as the bonding filler metal, In (indium) was uniformly applied in an average thickness of 0.15 mm, whereby the results were the same except that the bonding strength was 80 kg/cm².

### (Comparative Example 1)

On the surface of the same cylindrical substrate as in Example 1, copper as a bonding filler metal was thermally sprayed for coating in an average thickness of 0.3 mm. A covering film was formed thereon by a method of thermally spraying the same mixed raw material powder as in Example 1 to obtain a target material. Further, the surface of this target material was ground to obtain a target material having a constant thickness. The target material thus obtained was the same as in Example 1 in the diameter, length and thickness, and its porosity was 2.03%. Further, the bonding strength by the bonding filler metal was 20 kg/cm².

In film forming by this sputtering target, when the input power was raised to 20 kW per 1 m in length of the target, up to partway in use, film formation was possible without abnormal discharge, but once abnormal discharge started, film formation became no longer possible.

### (Comparative Example 2)

A sputtering target was prepared in the same manner as in Example 1 except that no bonding filler metal was applied, whereby the same target material was obtained, but the target material was found to be not bonded at all to the substrate.

With respect to Example 1 and Comparative Example 1, their constructions and characteristics are summarized in Table 1.

**[Table 1]**

| | | Example 1 | Comparative Example 1 |
|---|---|---|---|
| Production method | | CIP method | Thermal spraying method |
| Substrate | | SUS | SUS |
| Bonding filler metal | | Indium | Copper |
| Average thickness of bonding filler metal (mm) | | 0.025 | 0.30 |
| Composition of target material (mass ratio) | | Zn:Sn=50:50 | Zn:Sn=50:50 |
| Porosity of target material (%) | | 0.36 | 2.03 |
| Bonding strength (kg/cm²) | | 100 | 20 |
| Input power during film formation | 20 kW/m | ⊚ | ○ |
| | 25 kW/m | ⊚ | × |

Porosity of target material: A target material portion was cut out by electro-discharge machining (wire cutting) to obtain a target material of about 10 mm square. This target material was dried at 110°C for 24 hours, whereupon the porosity was measured by an Archimedes method.

Bonding strength: The bonding portion of the bonding filler metal and the target material was cut out by electro-discharge machining (wire cutting) and pulled in a direction perpendicular to the bonding surface of the bonding filler metal and the target material, whereby the strength at the time when the bonding surface was peeled, was measured. The pulling rate was 0.5 mm per one minute, and the bonding surface of the sample was of a size of about longitudinal 10 mm × side 15 mm.

Input powder during film formation (per length): Calculated by dividing the input power to the target material in dual cathode sputtering by the length of the target. At that time, evaluation was made by the following standards.
⊚: Until termination in use, film formation was possible without abnormal discharge.
○: Up to partway in use, film formation was possible without abnormal discharge, but once abnormal discharge started, film formation became no longer possible.
×: From initial stage, abnormal discharge was observed, and film formation was impossible.

From the above results, it is evident that the sputtering target of the present invention has a dense target material, and a bonding filler metal is bonded without forming a thermal strain, whereby it is possible to maintain stabilized film formation while maintaining overall cooling of the target material during sputtering uniformly. In a case where the porosity is large, abnormal electrical discharge (arc discharge) is likely to occur during sputtering, whereby a splash is likely to scatter and deposit on a sputtering film, and such a trouble can also be prevented. Further, it is possible to reduce the amount of bonding filler metal to be used, whereby the production cost can effectively be reduced.

### INDUSTRIAL APPLICABILITY

The sputtering target of the present invention has a dense target material, and a bonding filler metal is bonded without forming a thermal strain, whereby so long as it has a composition which makes the porosity to be no more than 1.5%, there is no other restriction, and it is useful for applications where a uniform thin film is required.

The entire disclosure of Japanese Patent Application No. 2013-141665 filed on July 5, 2013 including specification, claims, drawings and summary is incorporated herein by reference in its entirety.

### REFERENCE SYMBOLS

- 1:: sputtering target,
- 2:: substrate,
- 3:: bonding filler metal,
- 4:: target material,
- 11A:: covering main body,
- 11B:: covering cap member,
- 11:: covering member

## Claims

1. A sputtering target having a target material provided, via a bonding filler metal, on the surface of a cylindrical substrate, wherein the target material is a dense substance having a porosity of no more than 1.5%, and the thickness of the bonding filler metal is no more than 0.2 mm.

2. The sputtering target according to Claim 1, wherein the target material is continuously formed with its length being at least 1.0 m in the axial direction of the substrate.

3. The sputtering target according to Claim 1 or 2, wherein the temperature at which whole or part of the target material becomes a liquid phase, is at most 450°C.

4. The sputtering target according to Claim 3, wherein the target material contains at least one member selected from the group consisting of Zn, Sn and Al.

5. The sputtering target according to Claim 4, wherein the target material is an alloy of Zn-Sn type or Zn-Al type.

6. The sputtering target according to any one of Claims 1 to 5, wherein the melting point of the bonding filler metal is at most 300°C.

7. The sputtering target according to Claim 6, wherein the bonding filler metal is In, an In alloy, Sn or a Sn alloy.

8. The sputtering target according to any one of Claims 1 to 7, wherein the target material is bonded as dispersed in the bonding filler metal at the bonding surface with the bonding filler metal.

9. A process for producing a sputtering target, which comprises a coating step of applying a bonding filler metal on the surface of a cylindrical substrate, and a pressing step of placing a raw material powder to form a target material, on the surface of the bonding filler metal applied on the surface of the substrate, and subjecting the raw material powder to pressing treatment under a condition of at most 70°C by a cold isostatic pressing method (CIP method) to form a target material.

10. The process for producing a sputtering target according to Claim 9, wherein the cold isostatic pressing method is a wet rubber pressing method.

11. The process for producing a sputtering target according to Claim 9 or 10, wherein the porosity of the target material is no more than 1.5%.

12. The process for producing a sputtering target according to any one of Claims 9 to 11, wherein the thickness of the bonding filler metal is no more than 0.2 mm.

13. The process for producing a sputtering target according to any one of Claims 9 to 12, wherein the target material is continuously formed with its length being at least 1 m in the axial direction of the substrate.
